# EUROPEAN PATENT SPECIFICATION

(11) **EP 2 792 718 B1**
(45) Date of publication and mention of the grant of the patent: **08.02.2017**
(21) Application number: 12856825.0
(22) Date of filing: 13.12.2012
(51) Int. Cl.: C08L 101/00, C08K 3/34, C08K 5/3432, C08K 5/3445, C08K 5/56, C09K 11/06, C08J 5/18, C08J 7/04, C09D 11/037, C09D 11/322, C09D 11/328, C09D 11/50, C08K 5/00, C08K 9/04, H01L 51/00, H01L 51/50, H05B 33/14

(54) **LUMINESCENT RESIN COMPOSITION, FILM-SHAPED MOLDING OF SAME, AND POLYMER SELF-STANDING FILM**
LUMINESZIERENDE HARZZUSAMMENSETZUNG, FOLIENFÖRMIGE FORMUNG DAVON UND FREISTEHENDE POLYMERFOLIE
COMPOSITION DE RÉSINE LUMINESCENTE, SON MOULAGE EN FORME DE PELLICULE, ET PELLICULE AUTONOME DE POLYMÈRE

(30) Priority: 14.12.2011 JP 2011273797
(43) Date of publication of application: 22.10.2014
(73) Proprietor: National Institute for Materials Science, Tsukuba-shi, Ibaraki 305-0047 (JP)
(72) Inventor: TAMURA, Kenji, Ibaraki 305-0047 (JP); YAMAGISHI, Akihiko, Ibaraki 305-0047 (JP)
(74) Representative: Wenning, Ekkehard
(86) International application number: PCT/JP2012/007960
(87) International publication number: WO 2013/088720

(56) References cited:
- WO-A1-2010/037667
- JP-A- H02 103 033
- JP-A- H03 163 484
- JP-A- 2005 128 140
- JP-A- 2006 265 383
- JP-A- 2007 311 615
- JP-A- 2010 072 212
- JP-A- 2012 229 952
- MEDINA-CASTILLO A.L., FERNÁNDEZ-SÁNCHEZ J.F., KLEIN C., NAZEERUDDIN M.K., SEGURA-CARRETERO A., FERNÁNDEZ-GUTTIÉREZ, GRAETZEL M.: "Engineering of efficient phosphorescent iridium cationic complex for developing oxygen-sensitive polymeric and nanostructured films", ANALYST, vol. 132, 12 July 2007 (2007-07-12), pages 929-936, XP002742341,
- HISAKO SATO ET AL.: 'Hybridization of clay minerals with the floating film of a cationic Ir(III) complex at an air-water interface' NEW JOURNAL OF CHEMISTRY vol. 35, no. 2, February 2011, pages 394 - 399, XP055153979
- MICHAEL S. LOWRY ET AL.: 'Accelerated Luminophore Discovery through Combinatorial Synthesis' JOURNAL OF THE AMERICAN CHEMICAL SOCIETY vol. 126, no. 43, 2004, pages 14129 - 14135, XP009057980

## Description

### TECHNICAL FIELD

The present invention relates to a resin composition containing an iridium complex-layered silicate intercalated compound which can be used in an organic light emitting element (OLED) or the like, a film-shaped molding product of the same, and a polymer self-standing film.

### BACKGROUND ART

In recent years, in order to enlarge application of an OLED, material development in which a phosphorescence luminescent compound having a high light emission efficiency is being actively carried out. M. A. Baldo et al. obtain an external quantum efficiency of 7.5% by using an iridium complex which emits phosphorescent light from an excited triplet state, which is equivalent to an internal quantum efficiency of 37.5% when an external extraction efficiency is assumed to be 20%, and indicates that it is possible to exceed a value of 25% being an upper limit value of a case where a fluorescent dye is used (Non-patent Document 1).

An iridium metal complex has characteristics of being extinguished by oxygen, and an example of application of a composite body with a polymer to an oxygen sensor by using such characteristics is disclosed (Non-patent Document 2).

On the other hand, a layered silicate is a material abundant in a natural world, and is inexpensive. A clay-polymer nanocomposite film, which improves a gas barrier property dramatically while securing transparency of the film itself, is used not only for a food packaging material but also for a fuel tank of an automobile. Application of the clay-polymer nanocomposite film, which exhibits a high gas barrier property, to an oxygen barrier film of a light emitting element or the like can be expected (Non-patent Document 3). Further, it is obvious that a light emission lifetime of an iridium complex absorbed by a clay surface under an oxygen atmosphere is longer than that of a free iridium complex (Non-patent Document 4).

### PRIOR ART DOCUMENT

### NON-PATENT DOCUMENT

Non-patent Document 1: Applied Physical Letter, 1999, 75, 4.
Non-patent Document 2: Chemistry of Materials, 2009, 21, 2173.
Non-patent Document 3: Chemistry of Materials, 2001, 13, 2217.
Non-patent Document 4: New Journal of Chemistry, 2010, 34, 617.
Non-patent Document 5: "Clay Handbook" second edition, by The Clay Science Society of Japan, page 576 to page 577, published by Gihodo
Non-patent Document 6: Japan Bentonite Manufacturers Association Standard, JBAS-107-91
Non-patent Document 7: Chem. Mater., 1999, 11, 3342.
Non-patent Document 8: Transition Met. Chem., 1986, 11, 443. J. Chem. Soc., Dalton Trans. 2001, 2641.
Non-patent Document 9: Bioorganic & Medical Chem. Lett. 1995. 5, 2989.
Non-patent Document 10: Analyst, 2007,132,929-936

### SUMMARY OF THE INVENTION

### PROBLEMS TO BE SOLVED BY THE INVENTION

A material having a certain level of flexibility and exhibiting stable emission characteristics is demanded. It is an object of the present invention to provide a light emitting material in which an intercalated compound in which a cationic metal complex is intercalated to a layered silicate is fine-dispersed in a polymer matrix, and a molding product of the same.

### MEANS OF SOLVING THE PROBLEMS

According to an aspect of the present invention, there is given a phosphorescence luminescent resin composition having: an intercalated compound in which a cationic iridium complex indicated by a general formula below is intercalated between layers of a layered silicate; and a polymer in which the intercalated compound is dispersed, wherein the intercalated compound and the polymer are compounded.

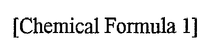

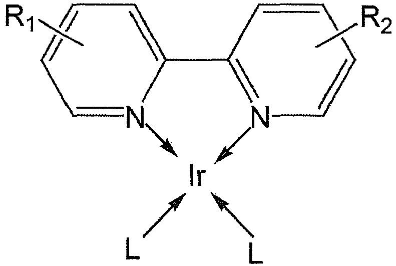

In the formula, R₁, R₂ each indicate an alkyl group, and L indicates a cyclometalated ligand. As is exemplified below, that cyclometalated ligand emits light as a result that N (nitrogen) and C (carbon) of the cyclometalated ligand is coordinated to Ir in the above-described general formula.

Here, at least one of R₁ and R₂ in the cationic iridium complex can have a carbon number of 9 or more.

Further, L (cyclometalated ligand) in the cationic iridium complex can be indicated by a following formula.

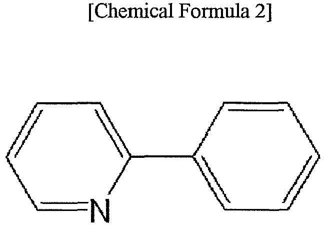

Further, L (cyclometalated ligand) in the cationic iridium complex can be indicated by a following formula.

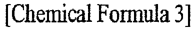

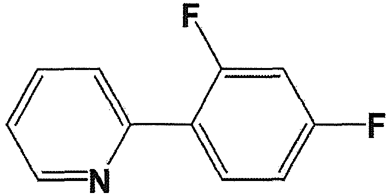

Further, L (cyclometalated ligand) in the cationic iridium complex can be indicated by a following formula.

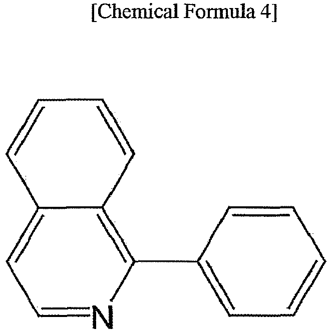

Further, L (cyclometalated ligand) in the cationic iridium complex can be indicated by a following formula.

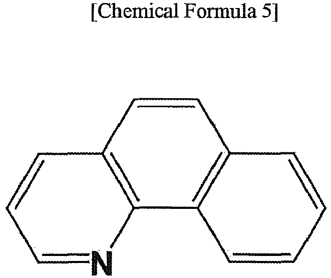

Further, L (cyclometalated ligand) in the cationic iridium complex can be indicated by a following formula.

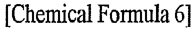

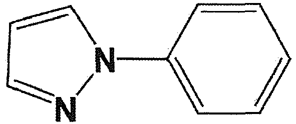

As a result of having L (cyclometalated ligand) indicated by the chemical formula 2, the cationic iridium complex indicated by the chemical formula 1 can emit light of a green region efficiently in a triplet-state MLCT (Metal To Charge Transfer). Further, as a result of having L (cyclometalated ligand) indicated by the chemical formula 3, the cationic iridium complex indicated by the chemical formula 1 can emit light of a blue region efficiently in the triplet-state MLCT (Metal To Charge Transfer). Further, as a result of having L (cyclometalated ligand) indicated by the chemical formula 4, the cationic iridium complex indicated by the chemical formula 1 can emit light of a red region efficiently in the triplet-state MLCT (Metal To Charge Transfer).

Similarly, as a result of having L (cyclometalated ligand) indicated by the chemical formula 5, the cationic iridium complex indicated by the chemical formula 1 can emit light of a green region efficiently in a triplet-state MLCT (Metal To Charge Transfer). Further, as a result of having L (cyclometalated ligand) indicated by the chemical formula 6, the cationic iridium complex indicated by the chemical formula 1 can emit light of a green region efficiently in a triplet-state MLCT (Metal To Charge Transfer).

Further, the layered silicate can be a smectite.

Further, the polymer can be a thermoplastic polymer.

Further, the polymer can be a thermosetting polymer.

Further, the polymer can be an energy ray curable polymer.

Further, a ratio of the intercalated compound in relation to the polymer can be 0.1 to 10 mass%. This is for the reason of enhancing dispersibility of the intercalated compound and stabilizing light emission characteristics and flexibility.

According to another aspect of the present invention, there is given a film-shaped molding product made by applying and drying any one of the above phosphorescence luminescent resin composition on a supporting body.

According to still another aspect of the present invention, there is given a polymer self-standing film of 5 to 200µm in thickness constituted by any one of the above phosphorescence luminescent resin compositions.

### EFFECT OF THE INVENTION

According to the present invention, it is possible to provide a material which has stable emission characteristics and flexibility and is excellent in molding workability. Thereby it is possible to produce a plastic film which is transparent when not excited and emits light by excitation, for example.

### BRIEF DESCRIPTION OF THE DRAWINGS

[Fig. 1a] Fig. 1a is a general formula indicating a structure of a hydrophobic ligand and a structural formula indicating an example;
[Fig. 1b] Fig. 1b is a general formula indicating a structure of a hydrophobic ligand and a structural formula indicating an example;
[Fig. 1c] Fig. 1c is a general formula indicating a structure of a hydrophobic ligand and a structural formula indicating an example;
[Fig. 2a] Fig. 2a is a structural formula of a ligand (cyclometalated ligand) for light emission;
[Fig. 2b] Fig. 2b is a structural formula of a ligand (cyclometalated ligand) for light emission;
[Fig. 2c] Fig. 2c is a structural formula of a ligand (cyclometalated ligand) for light emission;
[Fig. 2d] Fig. 2c is a structural formula of a ligand (cyclometalated ligand) for light emission;
[Fig. 2e] Fig. 2e is a structural formula of a ligand (cyclometalated ligand) for light emission;
[Fig. 3] Fig. 3 is a diagram showing a method for fabricating an iridium complex;
[Fig. 4a] Fig. 4a is a structural formula indicating an example of an iridium complex;
[Fig. 4b] Fig. 4b is a structural formula indicating an example of an iridium complex;
[Fig. 4c] Fig. 4c is a structural formula indicating an example of an iridium complex;
[Fig. 5] Fig. 5 is a schematic diagram showing an example of a crystal structure of a layered silicate represented by a smectite;
[Fig. 6] Fig. 6 is a graph showing a light emission spectrum of an iridium complex;
[Fig. 7] Fig. 7 is a measurement result of an X ray diffraction of a saponite (SAP) and a saponite-iridium complex intercalated compound; and
[Fig. 8] Fig. 8 is a configuration diagram of a light emission lifetime measurement apparatus.

### DETAILED DESCRIPTION OF THE EMBODIMENTS

A phosphorescence luminescent resin composition of the present invention has an intercalated compound in which a cationic iridium complex is intercalated between layers of a layered silicate and a polymer as essential constituents.

The cationic iridium complex will be described. The cationic iridium complex is required to be indicated by a chemical formula 1, and is preferable to be a cationic amphiphile iridium (III) complex.

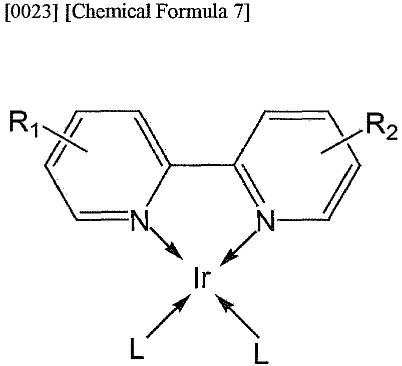

In the formula, R₁ and R₂ each indicate an alkyl group, and L indicates a cyclometalated ligand. As will be exemplified below, the cyclometalated ligand emits light as a result that N (nitrogen) and C (carbon) of the cyclometalated ligand are coordinated to Ir in the above-described general formula. Here, at least one of R₁ and R₂ in the cationic iridium complex can have a carbon number of 9 or more.

As a result that a cationic iridium complex has an amphiphile, that cationic iridium complex exhibits both properties of hydrophobic property and hydrophilic property. As a result that the cationic iridium complex exhibits the hydrophobic property, an affinity of the intercalated compound, in which the cationic iridium complex is intercalated, to the polymer of is increased. Thereby, it is possible to make the bond between the intercalated compound and the polymer stronger. Further, as a result that the cationic iridium complex exhibits the hydrophilic property, an interaction (ion-exchange) with the layered silicate is improved, and an interaction of the cationic iridium complex with the layered silicate is increased. Therefore, it is possible to obtain an effect of the aforementioned intercalation sufficiently.

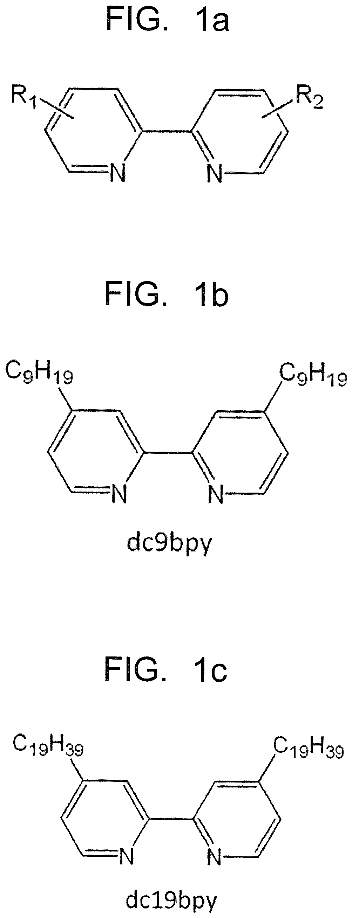

The cationic amphiphile iridium (III) complex has three ligands in an iridium metal. Fig. 1a is a general formula indicating a structure of a hydrophobic ligand, and Fig. 1b and Fig. 1c are structural formulas showing examples relating to the hydrophobic ligand. Both R₁ and R₂ shown in Fig. 1a are alkyl groups, and at least one thereof has 9 or more carbons. By using bpy fulfilling such a condition, the hydrophobic ligand is given. R₁ and R₂ can be the same, or can be different.

Fig. 1b is the structural formula of dC9bpy (4,4'-dinonyl-2,2'-bipyridine), and Fig. 1c is the structural formula of dCl9bpy (4,4'-dinonadecyl-2,2'-bipyridine).

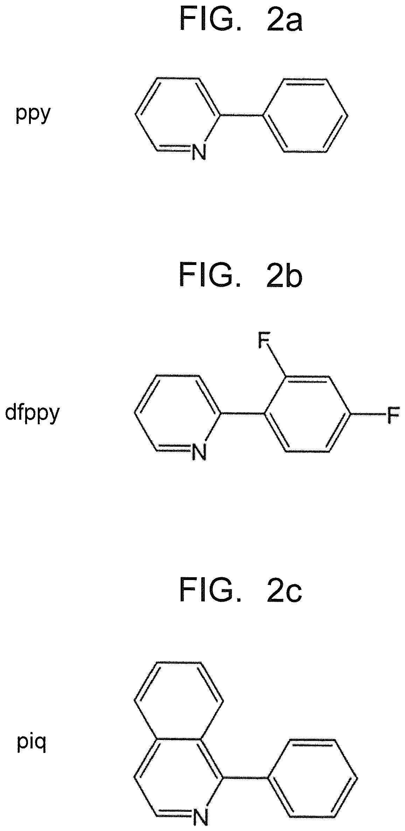

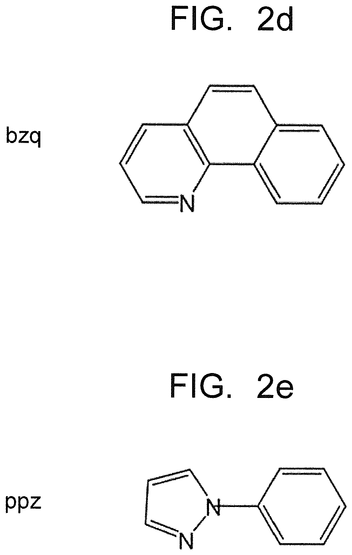

Fig. 2a to Fig. 2e are structural formulas of ligands for light emission, that is, of the cyclometalated ligands (L). Fig. 2a is the structural formula of ppy: 2-phenylpyridine, Fig. 2b is the structural formula of dfppy: 2-(2',4'-difluorophenyl)pyridine, Fig. 2c is the structural formula of piq: 1-phenyisoquinoline, Fig. 2d is the structural formula of bzq: benzo[h]quinoline, and Fig. 2e is the structural formula of ppz: phenylpyrazole. The iridium complexes having such ligands emit phosphorescence from a triplet-state MLCT (Metal To Charge Transfer).

As a result of having the cyclometalated ligand (L) shown in Fig. 2a, the cationic iridium complex indicated by the chemical formula 1 can emit light of a green region efficiently in a state of the triplet-state MLCT (Metal To Charge Transfer). Further, as a result of having the cyclometalated ligand (L) shown in Fig. 2b, the cationic iridium complex indicated by the chemical formula 1 can emit light of a blue region efficiently in the state of triplet-state MLCT (Metal To Charge Transfer). Further, as a result of having the cyclometalated ligand (L) shown in Fig. 2c, the cationic iridium complex indicated by the chemical formula 1 can emit light of a red region efficiently in the state of triplet-state MLCT (Metal To Charge Transfer).

Similarly, as a result of having the cyclometalated ligand (L) shown in Fig. 2d, the cationic iridium complex indicated by the chemical formula 1 can emit light of a green region efficiently in the state of triplet-state MLCT (Metal To Charge Transfer). Further, as a result of having L (cyclometalated ligand) shown in Fig. 2e, the cationic iridium complex indicated by the chemical formula 1 can emit light of a green region efficiently in the state of triplet-state MLCT (Metal To Charge Transfer).

Note that the cyclometalated ligand in the general formula 1 is not limited to the above, but any one already known in a field of a light emitting element using a metal complex can be used.

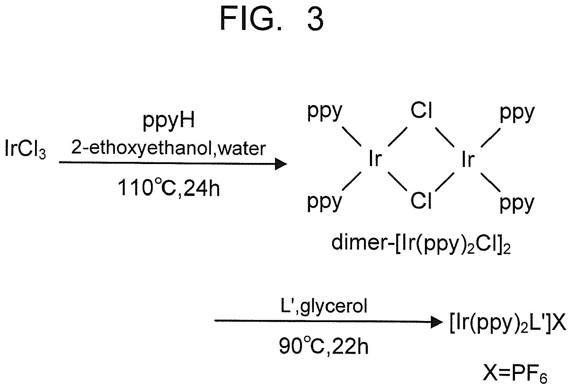

A method for fabricating an iridium complex will be described. Fig. 3 is a diagram showing the method for fabricating the iridium complex. Fig. 3 is an example in which ppy is added as a ligand for light emission. Into a solvent of 2-ethoxyethanol and water are dissolved ppyH and IrCl₃, and a reaction at 110°C for the thus obtained solution is carried out for 24 hours. Thereby, dimer-[lr-(ppy)₂Cl]₂ is generated.
Further, into with glycerol being a solvent are dissolved dimer-[lr(ppy)₂Cl]₂ and a hydrophobic ligand L', and a reaction at 180°C for the thus obtained solution is carried out for 6 hours or more. Thereby, [lr(ppy)₂L']X is generated. Here, X indicates a negative ion such as PF₆. Since dfppy, ppy, and piq are electrically neutral, by providing one dC9bpy or the like, the iridium complex becomes a positive ion.

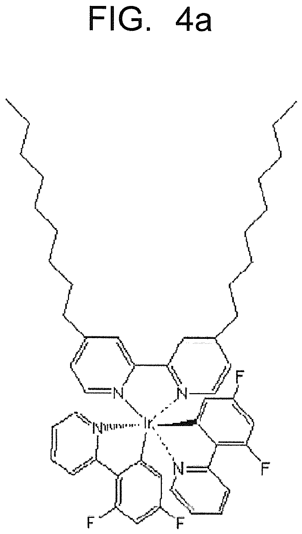

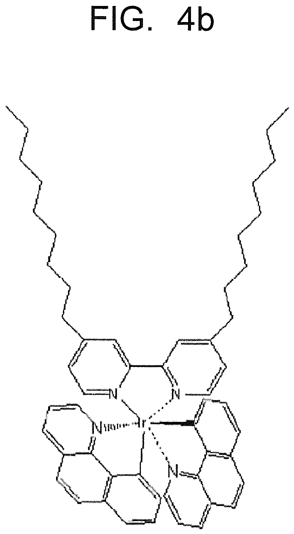

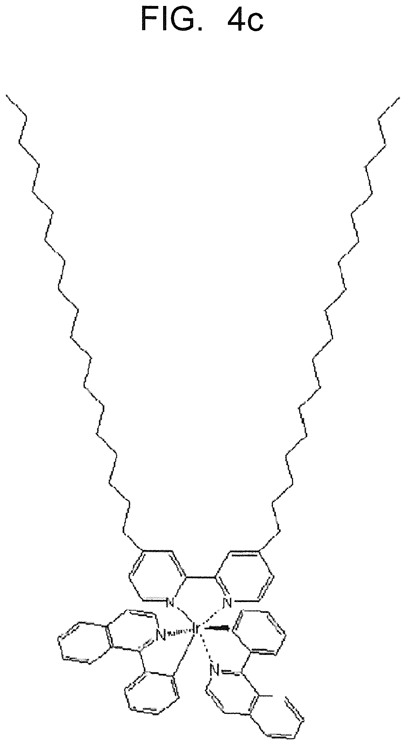

Fig. 4a to Fig.4c are structural formulas showing examples of the respective iridium complexes. Fig. 4a is the structural formula of the iridium complex having two dfppy and one dC9bpy as the ligands. Fig. 4b is the structural formula of the iridium complex having two bzq and one dC9bpy as the ligands. Fig. 4c is the structural formula of the iridium complex having two piq and one dC19bpy as the ligands.

In Fig. 4a to Fig. 4c, it is suitable to provide one hydrophobic ligand and two luminescent ligands in one iridium complex. As the number of the luminescent ligands increases, a light emitting performance is improved, but if all the ligands are luminescent ligands, the interaction between the cationic iridium complex and the layered silicate results in being small when the cationic iridium complex is intercalated to the layered silicate, so that the effect of the above-described intercalation sometimes results in being insufficient.

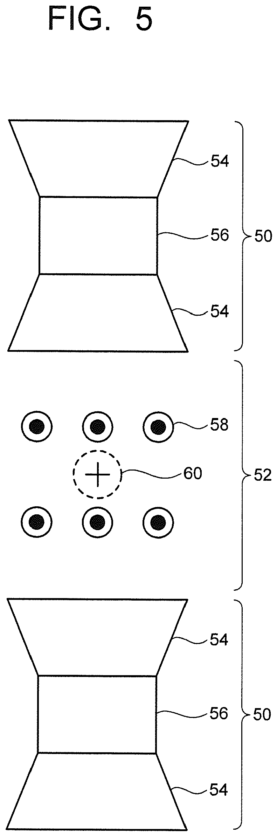

Next, the layered silicate will be described by using a smectite as an example. Fig. 5 is a schematic diagram showing an example of a crystal structure of the smectite. There is formed a composite layer 50 called 2: 1 type which has a structure in which (Si, Al)O₄ tetrahedral sheets 54 sandwich an MO₆ octahedral sheet (M: Mg, Fe, Al or the like) 56. The octahedral sheet 56 has 3 sites which the positive ions enter and bivalent positive ions such as Mg²⁺ and Fe²⁺ occupy all the three sites, but trivalent positive ions such as Al³⁺ occupy only two of three sites. The former is classified as three-octahedral type and the latter is classified as two-octahedral type. The smectite is a two-octahedral type or three-octahedral type 2: 1 layered silicate, and has a structure in which the composite layer 50 and a water molecule layer 52 are laminated. The water molecule layer 52 is constituted by water molecules 58 and an exchangeable positive ion 60 surrounded by the water molecules 58.

The layered silicate according to the present invention is not limited in particular, and there can be cited, concretely, a smectite represented by a montmorillonite, a beidellite, a nontronite, a saponite, a hectorite, and a stevensite, a mica such as a muscovite, a phlogopite, a taeniolite, a biotite, a margarite, a clintonite, and a four silicon mica, vermiculites such as a two-octahedral type vermiculite and a three-octahedral type vermiculite being altered minerals of mica, a mica clay mineral such as an illite, a sericite, a glauconite, and a celadonite, and so on. Such a layered silicate can also be a natural mineral, or can also be a synthetic compound by hydrothermal synthesis, scorification, solid phase synthesis, or the like. Further, in the present invention, one kind of the above-described layered silicates can be used independently, or two or more kinds thereof can be used combinedly. Particularly, a smectite swelling in a water system solvent and a expandable mica are suitable in intercalating a cationic iridium complex.

In a case of an easily ion exchangeable or expandable layered silicate such as a smectite or a expandable mica, an intercalated compound can be easily prepared by carrying out an ion exchange treatment in a positive charge organic compound solution having a comparatively low concentration of a one-fold to five-fold equivalent weight of a cation exchange capacity (CEC). As a measuring method of the CEC, a method such as a column infiltration method (see Non-patent Document 5) and a methylene blue adsorption method (see Non-patent Document 6) can be exemplified. However, in a case of a non-expandable layered silicate having a potassium ion or the like between layers, it is necessary to carry out the ion exchange treatment under a high temperature condition of 60°C or more in a positive charge organic compound solution having a high concentration of a five-fold to twenty-fold equivalent weight of the cation amount between the layers, and adjustment of a reaction condition is necessary depending on the combination of raw materials. The cation amount between the layers in such a case is estimated based on an analysis of a chemical composition. Concretely, an inductively coupled plasma (ICP) spectroscopy, an X-ray fluorescence analysis (XRF), an electron probe X-ray microanalyzer (EPMA), or the like is used.

A method for fabricating an intercalated compound in which a cationic iridium complex is intercalated to a layered silicate will be described. A layered silicate such as a smectite is fed into water to have a concentration of 1 to 3 mass% and is stirred In a case of the smectite, exfoliation occurs and the layered silicate becomes a layered silicate sheet 10 as thin as about 1 nm. The cationic iridium complex is dissolved in a water/alcohol mixed solvent, but since the solubility of the cationic iridium complex depends on the molecular structure thereof, the cationic iridium complex can be dissolved by properly changing the proportion of water/alcohol, the kind of alcohol, dissolving temperature, or the like. A cationic iridium complex solution is slowly dropped into a suspension of the layered silicate, and is stirred out for several hours. After stirring, filtration is performed and cleaning in a mixed solvent of water/ethanol (1: 1) is carried out. The above is repeated for several times so that an unreacted cationic iridium complex is removed, and thereafter, drying is carried out to prepare an intercalated compound.

As a polymer constituting the phosphorescence luminescent resin composition of the present invention, there can be cited a thermoplastic polymer, a thermosetting polymer, an energy ray curable polymer, and so on, which are transparent in a desired range of a light wavelength, but any polymer can be used and there is no limitation in particular. The suitable polymer can be amorphous or partially crystalline, and can include a homopolymer, a copolymer, or a mixture thereof.

As examples of the polymer, there can be cited high-density polyethylene (HDPE), low-density polyethylene (LDPE), linear low-density polyethylene (LLDPE), polypropylene (PP), ethylene-propylene copolymer, ethylene-butene copolymer, ethylene-hexene copolymer, ethylene vinyl acetate copolymer, ethylene methacrylate copolymer, polyolefin resin such as ionomer resin, poly(carbonate) (PC), syndiotactic or isotactic poly(styrene) (PS), C1 to C8 alkylstyrene, alkyl containing poly(methylmethacrylate) (PMMA) and PMMA copolymer, aromatic series and aliphatic series ring (meth)acrylate, ethoxylated or propoxylated (meth)acrylate, polyfunctional (meth)acrylate, polyether acrylate, epoxy acrylate, urethane acrylate, polybutadiene acrylate, silicone acrylate, melamine acrylate, acrylated epoxy, phenol resin, silicone resin, epoxy resin and other ethylenically unsaturated materials, cyclic olefin and cyclic olefin copolymer, polyvinyl carbazole, acrylonitrile butadiene styrene (ABS), styrene-acrylonitrile copolymer (SAN), poly(vinylcyclohexane), PMMA/poly(vinyl fluoride) blend, styrene-based block copolymer, polyimide, halogen containing resin such as polysulfone, polyvinyl chloride, polyvinylidene chloride and polyvinylidene fluoride, poly(dimethylsiloxane) (PDMS), polyurethane, saturated polyester, poly(alkane terephthalate) such as, for example, poly(ethylene terephthalate) (PET), poly(alkane naphthalate) such as, for example, poly(ethylene naphthalate) (PEN), polyamide resin such as polyamide 6, polyamide 66, polyamide 11, polyamide 12, aromatic series polyamide, and polymethacrylimide, and copolymer thereof, ionomer, vinyl acetate/ polyethylene copolymer, cellulose acetate, cellulose acetate butyrate, fluoropolymer, poly(styrene)-poly(ethylene) copolymer, polyolefin based PET and PET containing PEN and PEN copolymer, and poly(carbonate)/aliphatic PET blend, but the polymer is not limited to the above.

Note that a term (meth)acrylate is defined as either one of corresponding methacrylate and acrylate compound. These polymers can be used in a form of optical isotropy. These can be independent, or can be a polymer alloy of the combination thereof.

As a method for compounding the aforementioned polymer and the intercalated compound made of the cationic iridium complex and the layered silicate, there is used a solvent method of mixing the above polymer and the intercalated compound in a solvent, a method of directly mixing the polymer and the intercalated compound, or the like. In a case of the polymer which is solid at a room temperature, it is possible to use a method of melting and kneading. For example, the compound can be made by using a known melting and kneading method such as using a Banbury mixer, a Brabender, a kneader, a roll, a single-axis or multi-axis extruder, and a Ko-kneader.

In a case of the solvent method, the mixing and compounding for the raw materials of the polymer and the intercalated compound can be carried out by a known method such as a stirring reactor, a stirring type homogenizer, an ultrasonic homogenizer, a mortar, a microwave, a three-roll mill, and a bead mill. As concrete examples of the solvent to be used, the solvent being not limited in particular as long as the polymer is dissolved, there can be cited solvents such as water, methanol, ethanol, isopropyl alcohol, butanol, benzyl alcohol, ethylmethylketone, methylisobutylketone, cyclohexanone, ethyl acetoacetate, γ-butyrolactone, butyl acetate, cellosolve series, carbitol, N,N-dimethylformamide, N,N-dimethylacetamide, N,N-dimethylformamide, N-methyl-2-pyrrolidone, dimethylsulfoxide, phenol, a cresol, toluene, xylene, hexamethylbenzene, tetralin, decalin and dipentene. The above can be used independently, and can be used as a mixture of a combination of two kinds or more thereof.

When the phosphorescence luminescent resin composition of the present invention is to be applied onto a supporting body, it is possible to use an ink state composition prepared by the solvent method or the like. By applying and drying the phosphorescence luminescent resin composition of the present invention on the supporting body as above, a film-shaped molding product, for example, can be obtained.

It is preferable that the viscosity of the phosphorescence luminescent resin composition containing the solvent is adjusted to be 500 cP to 500,000 cP [measured at 25°C by a Brookfield viscometer]. The viscosity is more preferably 1,000 cP to 500,000 cP. A used amount of the solvent is preferable to be 0.1 to 2 folds by mass of a solid content other than the solvent, in consideration of simplicity in a drying process step. If the used amount exceeds two folds by mass, a solid content concentration becomes low and a sufficient film thickness cannot be obtained by one printing when used as a printing ink, there being a possibility that multiple times of printing are required.

As a concrete usage, roller coating, spin coating, screen coating, and curtain coating are possible, and screen printing, ink jet printing, and so on are exemplified.

The supporting body is not limited in particular, and can be, for example, a polymer film made of polyester resin such as polyethylene terephthalate and aliphatic series polyester or polyolefin resin such as polypropylene and low-density polyethylene, and electrically conductive glass such as glass, ITO, and tin oxide. The polymer film is preferable in view of flexibility.

Further, in manufacturing a molding product from a material compounded by a method such as melt-mixing, the molding method is not limited in particular, and any of injection molding, extrusion molding, blow molding, inflation molding, contour extrusion molding, injection blow molding, vacuum pressure molding, fiber forming, electric field fiber forming, and so on can be used suitably. The form, the thickness or the like of the molding product of the present invention is not limited in particular, either, and the molding product can be formed in any shape of an injection molded product, an extrusion molded product, a compression molded product, a blow molded product, a sheet shaped product, a film shaped product, a fiber shaped product, a fabric shaped product, and so on. For example, a polymer self-standing film can be formed by forming the molding product tin the film shape, or a polymer self-standing film can be formed by coating on a supporting body and then removing the supporting body. Thereby, it is possible to give a polymer self-standing film of 5 to 200 µm in thickness, for example. It is a matter of course that one thinner or thicker than the above can be fabricated, if necessary.

### EXAMPLE

Hereinafter, the present invention will be described in more detail by examples.

### (Test Example 1)

As a cationic iridium complex, there are synthesized <Ir(dfppy)₂dC9bpy>, <Ir(piq)₂dC19bpy>, and <Ir(bzq)₂dC19bpy> below.

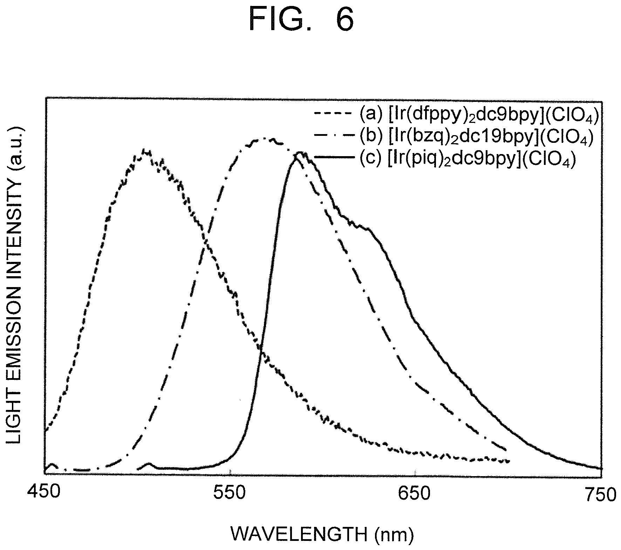

<Ir(dfppy)₂dC9bpy>: With glycerol (150g) being a solvent, 0.32 g of dimer-[Ir(dfppy)₂Cl]₂ (FW1246, FURUYA METAL Co., Ltd.) and 0.24 g of 4,4'-dinoryl-2,2' bipyridine dC9bpy (FW409, TOKYO CHEMICAL INDUSTRY CO., LTD.) were dissolved, and stirring at 180°C was carried out for 6 hours while bubbling with N₂ was being performed. After the reaction was finished, water and sodium perchlorate were added. Then, the thus obtained reactant was separated and the thus obtained high-purity component was extracted by chloroform. As a result, the sample of [Ir(dfppy)₂dC9bpy] (ClO₄) was obtained. The light emission spectrum of the sample was measured by a fluorescence spectrophotometer (FP-6500, JASCO Corporation). The obtained light emission spectrum is shown in a graph a in Fig. 6. A peak wavelength is about 500 nm.

### (Text Example 2)

<Ir(bzq)₂dC9bpy>: With glycerol (150g) being a solvent, 0.32 g of dimer-[Ir(bzq)₂Cl]₂ (FW1246, FURUYA METAL Co., Ltd.) and 0.24 g of 4,4'-dinoryl-2,2'bipyridine dC9bpy (FW409, TOKYO CHEMICAL INDUSTRY CO., LTD.) were dissolved, and stirring at 180°C was carried out for 6 hours while bubbling with N₂ was being performed. After the reaction was finished, water and sodium perchlorate were added, and thereafter, the thus obtained high-purity component was extracted by chloroform, and the sample of [Ir(bzq)₂dC9bpy] (ClO₄) was obtained. A light emission spectrum of the obtained sample is shown in a graph b in Fig. 6. A peak wavelength is about 560 nm.

### (Test Example 3)

<Ir(piq)₂dC19bpy>: According to Non-patent Documents 7 to 9, 4,4'- dinonadecyl-2,2' bipyridine(dC19bpy) was prepared. With glycerol (130g) being a solvent, 0.326 g of dimer-[Ir(piq)₂Cl]₂ (FW1271, FURUYA METAL Co., Ltd.) and 0.39 g of dC19bpy (FW689) were dissolved, and stirring at 180°C was carried out for 6 hours while bubbling with N₂ was being performed. After the reaction was finished, water and sodium perchlorate were added. Then, the thus obtained reactant was separated and the thus obtained high-purity component was extracted by chloroform. As a result the sample of [Ir(piq)₂dC19bpy] (ClO₄) was obtained. A light emission spectrum of the obtained sample is shown in a graph c in Fig. 6. A peak wavelength is about 600 nm.

### (Light Emission Lifetime Measurement)

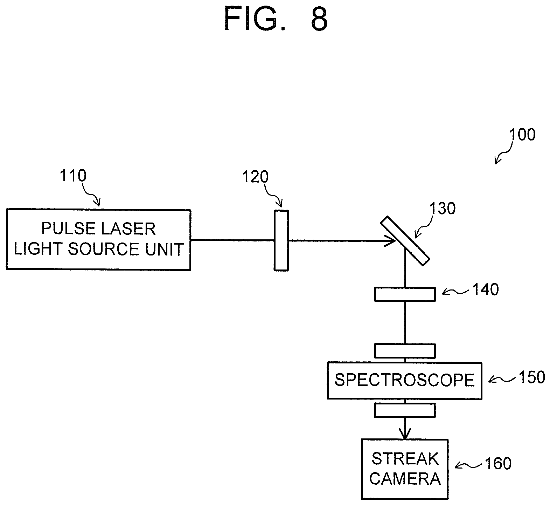

First, a light emission lifetime measurement apparatus used in the present example will be described. Fig. 8 is a configuration diagram 100 of the light emission lifetime measurement apparatus used in the present example. An arrow indicates light (excitation light or light emission).

In Fig. 8, the present example has a configuration constituted by a pulse laser light source unit 110, a light-reducing (neutral density) filter 120, a measurement sample unit 130, a lens 140, a spectroscope 150, and a streak camera 160. A sample to be measured is fixed on a quartz glass plate. Then, light emission lifetime measurement in a center wavelength of a light emission spectrum of each sample is carried out. A light emission lifetime τ is calculated from an obtained luminescence decay curve.

### [Example 1]

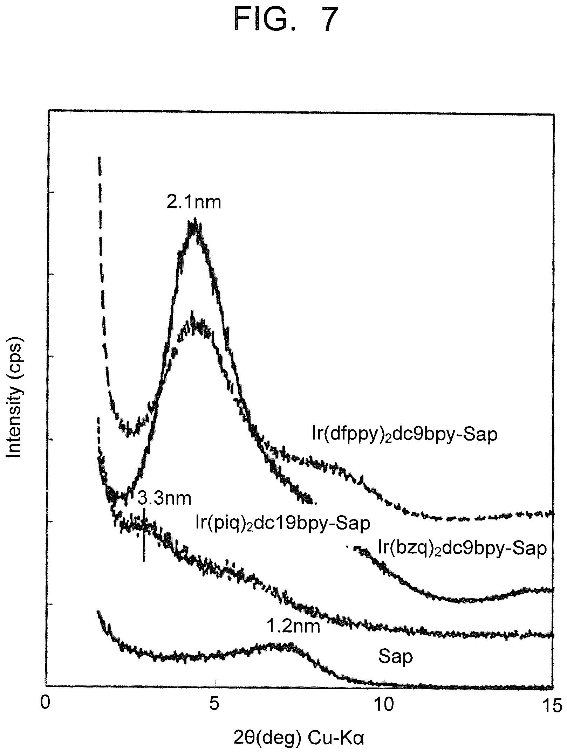

As a layered silicate, 1.5 g of synthetic saponite (Smecton, KUNMNE INDUSTRIES CO., LTD.) was added to 200 mL of distilled water, then stirred and dispersed, so that the corresponding suspension was prepared. Further, 0.5 g of the cationic iridium complex [Ir(dfppy)₂dC9bpy] (ClO₄) obtained in the test example 1 was dissolved in water/methanol mixed solvent and thereafter fed into the saponite suspension. Then, the thus obtained solution was stirred and mixed for about 3 hours, and the thus obtained reactant was repeatedly filtered and cleaned. After the drying the reactant, a powdered sample was obtained. For evaluation of the obtained sample, change of bottom face reflection of the layered silicate was investigated by an X-ray diffraction instrument (Cu-Kα radiation). While the bottom face interval of untreated saponite was 1.2 nm, the bottom face interval of the sample after reaction was about 2.0 nm (Fig. 7). In other words, [Ir(dfppy)₂dC9bpy]-Sap in which the corresponding Ir(dfppy)₂dC9bpy molecule was intercalated between clay layers was prepared.

As the polymer, polymethyl methacrylate PMMA (Mw: 120000, Sigma-Aldrich Co., LLC.) was used and 3 g of PMMA was dissolved into 100 mL of dimethylformamide, and further, 1 phr of [Ir(dfppy)₂dC9bpy]-Sap in relation to the polymer was added, then stirred and mixed at about 80°C for 3 hours. Thereafter, the thus obtained mixture was fed into a methanol/water mixed solvent, precipitated and dried to obtain a resin composition. The dried resin composition was subjected to thermal press at 260°C and 100 MPa to form a film of 20 µm. The center wavelength of the light emission spectrum of the film was about 500 nm. As a result of light emission lifetime measurement (Table 1), the light emission lifetimes of two components are observed, which are τ₁: 1.48 µs and τ₂: 4.82 µs, respectively, which shows that the component having the longer light emission lifetimes is detected in comparison with the [Ir(dfppy)₂dC9bpy] (ClO₄) and the [Ir(dfppy)₂dC9bpy]-Sap as the raw materials.

### [Example 2]

A sample was prepared completely similarly to in the example 1 except that the cationic iridium complex described in the example 1 was replaced by [Ir(bzq)₂dC9bpy] (ClO₄) obtained in the test example 2. The bottom face interval of the thus obtained [Ir(bzq)₂dC9bpy]-Sap was enlarged to 2.1 nm (Fig. 7). As the light emission spectrum investigation, a luminescent film having a center wavelength of about 550 nm was prepared. As a result of the light emission lifetime measurement (Table 1), the light emission lifetimes of two components are observed, which are τ₁: 1.54 µs and τ₂: 10.65 µs, respectively, which shows that the component having the longer light emission lifetimes is detected in comparison with the [Ir(bzq)₂dC9bpy] (ClO₄) and the [Ir(bzq)₂dC9bpy]-Sap as the raw materials.

### [Example 3]

With the cationic iridium complex described in the example 1 being replaced by[Ir(piq)₂dC19bpy] (ClO₄) obtained in the test example 3, [Ir(piq)₂dC19bpy]-Sap was prepared by a procedure of the example 1. A result of X-ray diffraction measurement indicates that the bottom face interval was enlarged to about 3.3 nm (Fig. 7). The polymer and the [Ir(piq)₂dC19bpy]-Sap were blended at the same compounding ratio as that in the example 1, and with a Labo plastomill (TOYO SEIKI SEISAKU-SHO, LTD.) being equipped with a mixer unit, a melt mixing treatment for the thus obtained blended compound was carried out at 260°C. The thus obtained mixture was processed to form a film of 20 µm in thickness by using thermal pressing. As a result of the light emission spectrum investigation, a luminescent film having a center wavelength of 600 nm was prepared. As a result of the light emission lifetime measurement (Table 1), light emission lifetimes of two components were observed, which are τ₁: 2.61 µs and τ₂: 6.17 µs, respectively, which shows that the component having the longer light emission lifetimes is detected in comparison with the [Ir(bzq)₂dC9bpy] (ClO₄) and the [Ir(bzq)₂dC9bpy]-Sap as the raw materials.

**TABLE. 1**

| | *τ* ₁[µs] | *τ* ₂[µs] |
|---|---|---|
| EXAMPLE 1 | 1.48 | 4.82 |
| EXAMPLE 2 | 1.54 | 10.65 |
| EXAMPLE 3 | 2.61 | 6.17 |
| EXAMPLE 4 | 1.36 | 5.37 |
| COMPARATIVE EXAMPLE 1 | 1.32 | 6.75 |
| COMPARATIVE EXAMPLE 2 | 2.54 | 5.63 |
| [Ir(dfppy)₂(dC9bpy)](ClO₄) | 0.61 | 2.49 |
| [Ir(bzq)₂(dC9bpy)](ClO₄) | 0.20 | 0.59 |
| [Ir(piq)₂(dC19bpy)](ClO₄) | 0.50 | 0.58 |
| [Ir(dfppy)₂(dC9bpy)]-Sap | 0.33 | 0.67 |
| [Ir(bzq)₂(dC9bpy)]-Sap | 0.60 | 1.18 |
| [Ir(piq)₂(dC19bpy)]-Sap | 0.78 | 3.68 |

### [Example 4]

A sample was prepared completely similarly to in the example 1 except that the synthetic saponite described in the example 1 was replaced by synthetic hectorite HT (SWN, Co-op Chemical Co., Ltd). The bottom face interval of [Ir(dfppy)₂dC9bpy]-HT was enlarged to about 2.0 nm. To 100 phr of PMMA was added 1phr of [Ir(dfppy)₂dC9bpy]-HT and a film of 20 µm in thickness was prepared by a solvent method using dimethylformamide. As the light emission spectrum investigation, a luminescent film having a center wavelength of about 490 nm was prepared. As a result of the light emission lifetime measurement (Table 1), the light emission lifetimes of two components are observed, which are τ₁: 1.36 µs and τ2. 5.37 µs, respectively, which shows that the component having the longer light emission lifetimes is detected in comparison with the [Ir(bzq)₂dC9bpy] (ClO₄).

### [Comparative Example 1]

A sample was prepared completely similarly to in the example 2 except that [Ir(bzq)₂dC9bpy] (ClO₄) was used instead of the intercalated compound [Ir(bzq)₂dC9bpy]-Sap used in the example 2. As the light emission spectrum investigation, a luminescent film having a center wavelength of about 490 nm was prepared. As a result of the light emission lifetime measurement (Table 1), the light emission lifetimes of two components are observed, which are τ₁: 1.32 µs and τ₂: 6.75 µs, respectively.

### [Comparative Example 2]

A sample was prepared completely similarly to in the example3 except that [Ir(piq)₂dC19bpy] (ClO₄) was used instead of the intercalated compound [Ir(piq)₂dC19bpy]-Sap used in the example 3. As the light emission spectrum investigation, a luminescent film having a center wavelength of about 490 nm was prepared. As a result of the light emission lifetime measurement (Table 1), the light emission lifetimes of two components are observed, which are τ₁: 2.54 µs and τ₂: 5.63 µs, respectively.

## Claims

1. A phosphorescence luminescent resin composition comprising:
an intercalated compound in which a cationic iridium complex indicated by a general formula below is intercalated between layers of a layered silicate; and
a polymer in which said intercalated compound is dispersed,
wherein said intercalated compound and said polymer are compounded. [Chemical Formula 1] 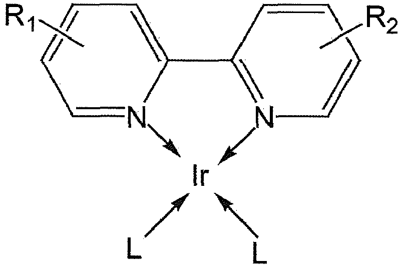 (In the formula, R₁, R₂ each indicates an alkyl group, and L indicates a cyclometalated ligand.)

2. The phosphorescence luminescent composition according to claim 1,
wherein at least one of R₁ and R₂ in the cationic iridium complex has a carbon number of 9 or more.

3. The phosphorescence luminescent resin composition according to claim 1 or 2, wherein L in the cationic iridium complex is indicated by a following formula.

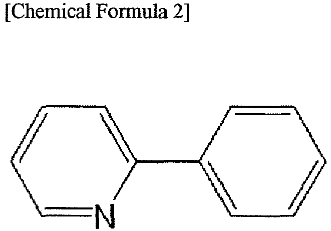

4. The phosphorescence luminescent resin composition according to claim 1 or 2, wherein L in the cationic iridium complex is indicated by a following formula.

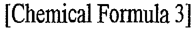

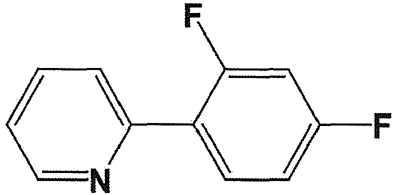

5. The phosphorescence luminescent resin composition according to claim 1 or 2, wherein L in the cationic iridium complex is indicated by a following formula.

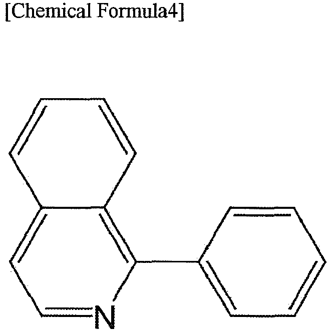

6. The phosphorescence luminescent resin composition according to claim 1 or 2, wherein L in the cationic iridium complex is indicated by a following formula.

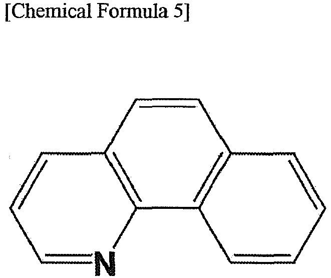

7. The phosphorescence luminescent resin composition according to claim 1 or 2, wherein L in the cationic iridium complex is indicated by a following formula.

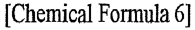

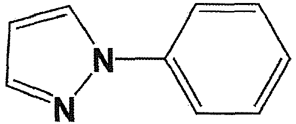

8. The phosphorescence luminescent resin composition according to any one of claims 1 to 6,
wherein the layered silicate is smectite.

9. The phosphorescence luminescent resin composition according to any one of claims 1 to 7,
wherein said polymer is a thermoplastic polymer.

10. The phosphorescence luminescent resin composition according to any one of claims 1 to 7,
wherein said polymer is a thermosetting polymer.

11. The phosphorescence luminescent resin composition according to any one of claims 1 to 7,
wherein said polymer is an energy ray curable polymer.

12. The phosphorescence luminescent resin composition according to any one of claims 1 to 10,
wherein a ratio of said intercalated compound in relation to said polymer is 0.1 to 10 mass%.

13. A film-shaped molding product made by applying and drying the phosphorescence luminescent resin composition according to any one of claims 1 to 12 on a supporting body.

14. A polymer self-standing film of 5 to 200 µm in thickness made of the phosphorescence luminescent resin composition according to any one of claims 1 to 12.

## Patentansprüche

1. Phosphoreszierend leuchtende Harzzusammensetzung, umfassend:
eine Interkalationsverbindung, in welcher ein durch die nachfolgende allgemeine Formel wiedergegebener kationischer Iridiumkomplex zwischen den Schichten eines Schichtsilikats eingelagert ist; und
ein Polymer, in welchem die Interkalationsverbindung dispergiert ist,
wobei die Interkalationsverbindung und das Polymer miteinander vermischt sind. 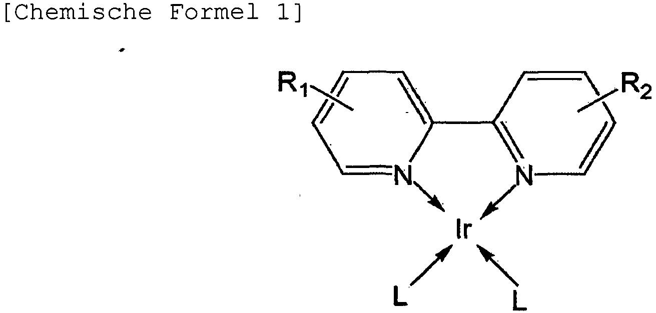 (in der Formel bezeichnen R₁ und R₂ jeweils eine Alkylgruppe, und bezeichnet L einen cyclometallierten Liganden.)

2. Phosphoreszierend leuchtende Zusammensetzung nach Anspruch 1, wobei zumindest eines von R₁ und R₂ in dem kationischen Iridiumkomplex 9 oder mehr Kohlenstoffe aufweist.

3. Phosphoreszierend leuchtende Harzzusammensetzung nach Anspruch 1 oder 2, wobei L in dem kationischen Iridiumkomplex durch die nachfolgende Formel wiedergegeben wird.

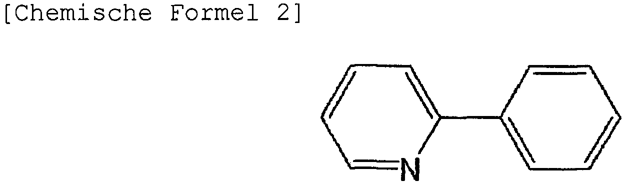

4. Phosphoreszierend leuchtende Harzzusammensetzung nach Anspruch 1 oder 2, wobei L in dem kationischen Iridiumkomplex durch die nachfolgende Formel wiedergegeben wird.

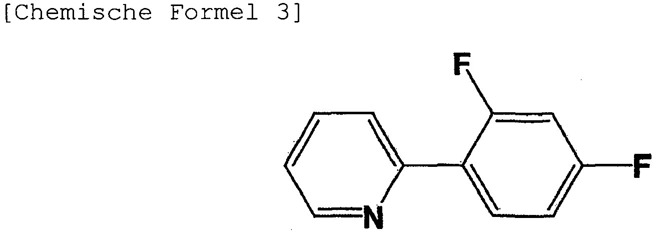

5. Phosphoreszierend leuchtende Harzzusammensetzung nach Anspruch 1 oder 2, wobei L in dem kationischen Iridiumkomplex durch die nachfolgende Formel wiedergegeben wird.

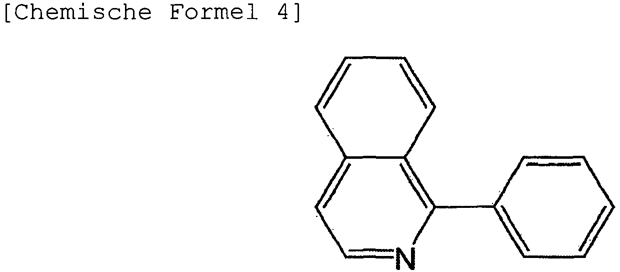

6. Phosphoreszierend leuchtende Harzzusammensetzung nach Anspruch 1 oder 2, wobei L in dem kationischen Iridiumkomplex durch die nachfolgende Formel wiedergegeben wird.

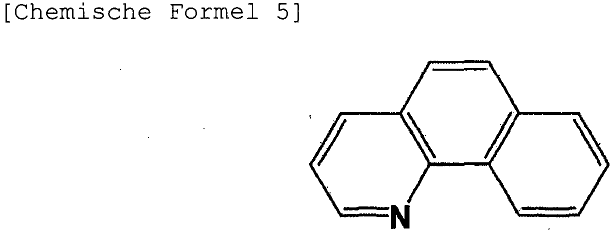

7. Phosphoreszierend leuchtende Harzzusammensetzung nach Anspruch 1 oder 2, wobei L in dem kationischen Iridiumkomplex durch die nachfolgende Formel wiedergegeben wird.

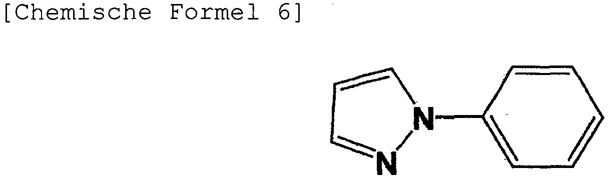

8. Phosphoreszierend leuchtende Harzzusammensetzung nach einem der Ansprüche 1 bis 6, wobei es sich bei dem Schichtsilikat um Smektit handelt.

9. Phosphoreszierend leuchtende Harzzusammensetzung nach einem der Ansprüche 1 bis 7, wobei es sich bei dem Polymer um einen Thermoplasten handelt.

10. Phosphoreszierend leuchtende Harzzusammensetzung nach einem der Ansprüche 1 bis 7, wobei es sich bei dem Polymer um einen Duroplasten handelt.

11. Phosphoreszierend leuchtende Harzzusammensetzung nach einem der Ansprüche 1 bis 7, wobei es sich bei dem Polymer um ein mittels Energiestrahlen härtbares Polymer handelt.

12. Phosphoreszierend leuchtende Harzzusammensetzung nach einem der Ansprüche 1 bis 10, wobei das Verhältnis von Interkalationsverbindung zu Polymer 0.1 bis 10 Masse% beträgt.

13. Folienförmiges Formteil, welches durch Aufbringen und Trocknen der phosphoreszierend leuchtenden Harzzusammensetzung nach einem der Ansprüche 1 bis 12 auf einen Trägerkörper erzeugt worden ist.

14. Freistehende Polymerfolie mit einer Dicke von 5 bis 200 µm, welche aus der phosphoreszierend leuchtenden Harzzusammensetzung nach einem der Ansprüche 1 bis 12 besteht.

## Revendications

1. Composition de résine luminescente par phosphorescence comprenant :
un composé intercalé dans lequel un complexe d'iridium cationique indiqué par la formule générale ci-dessous est intercalé entre des couches d'un silicate stratifié ; et
un polymère dans lequel ledit composé intercalé est dispersé,
dans lequel ledit composé intercalé et ledit polymère sont combinés. [Formule chimique 1] 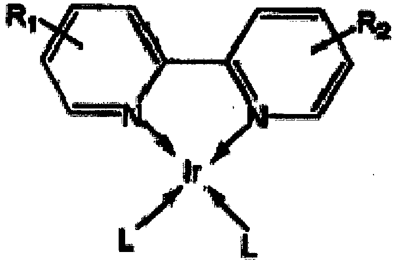 (dans la formule, R₁, R₂ indiquent chacun un groupe alkyle, et L indique un ligand cyclométallé).

2. Composition luminescente par phosphorescence selon la revendication 1,
dans laquelle au moins l'un de R₁ et R₂ dans le complexe d'iridium cationique a un nombre de carbones de 9 ou plus.

3. Composition de résine luminescente par phosphorescence selon la revendication 1 ou 2,
dans laquelle L dans le complexe d'iridium cationique est indiqué par la formule suivante.

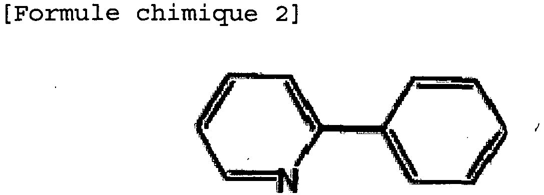

4. Composition de résine luminescente par phosphorescence selon la revendication 1 ou 2,
dans laquelle L dans le complexe d'iridium cationique est indiqué par la formule suivante.

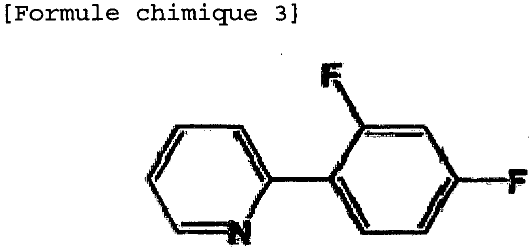

5. Composition de résine luminescente par phosphorescence selon la revendication 1 ou 2,
dans laquelle L dans le complexe d'iridium cationique est indiqué par la formule suivante.

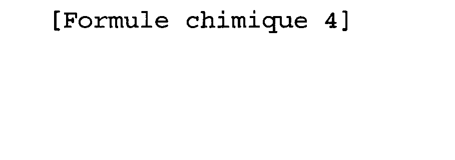

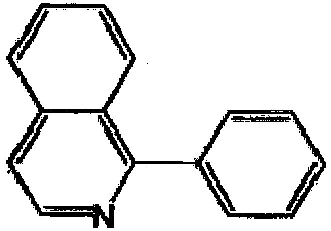

6. Composition de résine luminescente par phosphorescence selon la revendication 1 ou 2,
dans laquelle L dans le complexe d'iridium cationique est indiqué par la formule suivante.

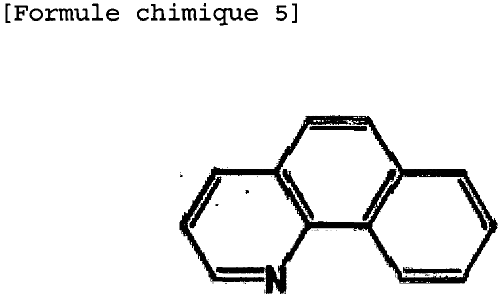

7. Composition de résine luminescente par phosphorescence selon la revendication 1 ou 2,
dans laquelle L dans le complexe d'iridium cationique est indiqué par la formule suivante.

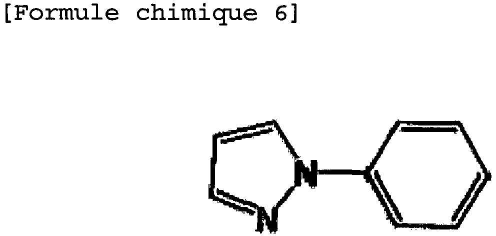

8. Composition de résine luminescente par phosphorescence selon l'une quelconque des revendications 1 à 6,
dans laquelle le silicate stratifié est la smectite.

9. Composition de résine luminescente par phosphorescence selon l'une quelconque des revendications 1 à 7,
dans laquelle ledit polymère est un polymère thermoplastique.

10. Composition de résine luminescente par phosphorescence selon l'une quelconque des revendications 1 à 7,
dans laquelle ledit polymère est un polymère thermodurcissable.

11. Composition de résine luminescente par phosphorescence selon l'une quelconque des revendications 1 à 7,
dans laquelle ledit polymère est un polymère durcissable par rayonnement d'énergie.

12. Composition de résine luminescente par phosphorescence selon l'une quelconque des revendications 1 à 10,
dans laquelle le rapport entre ledit composé intercalé et ledit polymère est de 0,1 à 10% en masse.

13. Produit de moulage en forme de film réalisé par l'application et le séchage de la composition de résine luminescente par phosphorescence selon l'une quelconque des revendications 1 à 12 sur un support.

14. Film autoporteur en polymère de 5 à 200 *µ*m d'épaisseur formé de la composition de résine luminescente par phosphorescence selon l'une quelconque des revendications 1 à 12.
